# EUROPEAN PATENT APPLICATION

(11) **EP 3 106 891 A1**
(43) Date of publication of application: **21.12.2016**
(21) Application number: 15176015.4
(22) Date of filing: 09.07.2015
(51) Int. Cl.: G01R 31/36

(54) **DEVICES AND METHODS FOR BATTERY DIAGNOSTICS**

(30) Priority: 15.06.2015 TW 104119220
(71) Applicant: Quanta Computer Inc., Taoyuan City 333 (TW)
(72) Inventor: YEN, Wei-Ting, 333 Taoyuan City (TW)
(74) Representative: Michalski Hüttermann & Partner Patentanwälte mbB

(57) **Abstract**

A state-detection device, adapted in a host, includes a battery, a gas gauge, a processor, and a display. The battery is operating in an operation state. The gas gauge is configured to instantly detect the operation state and stores state information of the battery in a plurality of registers. The processor determines, according to the state information, whether the battery is operating in a normal state, a temporary failure state, or a permanent failure state to generate state-determination information. When the battery is operating in the temporary failure state, the processor further determines whether the temporary failure state is an over-temperature state, an over-voltage state, or an over-current state according to a first value, a second value, and a third value, respectively, of the state information. The display is configured to display the state-determination information.

## Description

### CROSS REFERENCE TO RELATED APPLICATIONS

This Application claims priority of Taiwan Patent Application No. 104119220, filed on Jun 15, 2015, the entirety of which is incorporated by reference herein.

### BACKGROUND OF THE INVENTION

### Field of the Invention

The disclosure relates generally to devices and methods for detecting the state of a battery, and more particularly it relates to devices and methods for determining an abnormal state and providing troubleshooting suggestions according to the detected state of the battery.

### Description of the Related Art

In general, there is a communication path between a battery and an electronic device, and the communication path is configured to read and write the state between the battery and the electronic device. When the self-protection mechanism of the battery is activated due to an abnormality, the electronic device stops charging the battery and generates abnormal signals. However, the user usually has no idea what kind of abnormality is affecting the battery, and has no idea how to eliminate the root cause of the abnormality either, according to the abnormal signals generated by the electronic device. Therefore, we urgently need devices and methods for determining the type of abnormality affecting a battery and providing appropriate troubleshooting suggestions.

### BRIEF SUMMARY OF THE INVENTION

For solving above problems, the invention provides a state-detection device and method for battery diagnostics. The invention further provides the state-detection device and method for generating a troubleshooting suggestion according to the battery diagnosis.

An embodiment of a state-detection device, adapted to a host, comprises: a battery, a gas gauge, a processor, and a display. The battery is operating in an operation state. The gas gauge is configured to instantly detect the operation state to store state information of the battery in a plurality of registers. The processor determines whether the battery is operating in a normal state, a temporary failure state, or a permanent failure state, according to the state information to generate state-determination information. When the battery is operating in the temporary failure state, the processor further determines whether the temporary failure state is an over-temperature state, an over-voltage state, or an over-current state, according to a first value, a second value, and a third value, respectively, of the state information. The display is configured to display the state-determination information.

In an embodiment, the processor further determines whether the operation state is either a charging state or a discharging state according to whether a charger is coupled to the host or not. When the operation state is the temporary failure state of the charging state, the processor determines whether the temporary failure state is the over-temperature state based on an Over Temperature Alarm bit; determines whether the temporary failure state is the over-voltage state based on a Cell Overvoltage Condition bit; and determines whether the temporary failure state is the over-current state based on a Charge Overcurrent Condition bit.

In an embodiment, when the operation state is the temporary failure state of the discharging state, the processor determines whether the temporary failure state is the over-temperature state based on an Over Temperature Alarm bit, or whether the temporary failure state is the over-current state based on a Discharge Overcurrent Condition bit.

In an embodiment, when the operation state is the temporary failure state, the processor further displays, on the display, a troubleshooting suggestion corresponding to the over-temperature state, the over-voltage state, or the over-current state, so that the user is able to put the operation state back to the normal state according to the troubleshooting suggestion.

In an embodiment, the processor accesses the state information of the registers in a predetermined time interval a predetermined number of times, and determines that the operation state of the battery is either the normal state, the temporary failure state, or the permanent failure state, according to the state information that has been accessed a predetermined number of times. When the operation state is the temporary failure state, the processor determines whether the temporary failure state is the over-temperature state, the over-voltage state, or the over-current state, according to the state information that has been accessed the predetermined number of times.

An embodiment of a state detection method, adapted for a battery of a host, comprises: instantly detecting an operation state to be state information; storing the state information in a plurality of registers; determining, according to the state information, that the battery is operating in either a normal state, a temporary failure state, or a permanent failure state to generate state-determination information; when the battery is operating in the temporary failure state, determining whether the temporary failure state is an over-temperature state, an over-voltage state, or an over-current state according to a first value, a second value, and a third value, respectively, of the state information; and displaying the state-determination information by a display.

An embodiment of the state detection method further comprises: determining whether the operation state is a charging state or a discharging state according to whether a charger is coupled to the host or not. When the operation state is the temporary failure state of the charging state, the state detection method comprises determining whether the temporary failure state is the over-temperature state or not, based on an Over Temperature Alarm bit; determining whether the temporary failure state is the over-voltage state or not, based on a Cell Overvoltage Condition bit; and determining whether the temporary failure state is the over-current state or not, based on a Charge Overcurrent Condition bit.

An embodiment of the state detection method further comprises: when the operation state is the temporary failure state of the discharging state, determining whether the temporary failure state is the over-temperature state or not based on the Over Temperature Alarm bit; and determining whether the temporary failure state is the over-current state or not based on a Discharge Overcurrent Condition bit.

An embodiment of the state detection method further comprises: when the operation state is the temporary failure state, displaying a troubleshooting suggestion corresponding to each of the over-temperature state, the over-voltage state, and the over-current state by the display, so that the user is able to put the operation state back to the normal state according to the troubleshooting suggestion.

An embodiment of the state detection method further comprises: accessing the state information of the registers in a predetermined interval a predetermined number of times; determining that the operation state of the battery is either the normal state, the temporary failure state, or the permanent failure state according to the state information that has been accessed the predetermined number of times; and when the operation state is the temporary failure state, determining whether the temporary failure state is the over-temperature state, the over-voltage state, or the over-current state according to the state information that has been accessed the predetermined number of times.

A detailed description is given in the following embodiments with reference to the accompanying drawings.

### BRIEF DESCRIPTION OF DRAWINGS

The invention can be more fully understood by reading the subsequent detailed description and examples with references made to the accompanying drawings, wherein:
Fig. 1 is a block diagram of the state-detection device in accordance with an embodiment of the invention;
Fig. 2 is a flow chart of the state detection method in accordance with an embodiment of the invention;
Fig. 3 is a flow chart of the state detection method in the charging state in accordance with an embodiment of the invention; and
Fig. 4 is a flow chart of the state detection method in the discharging state in accordance with an embodiment of the invention.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

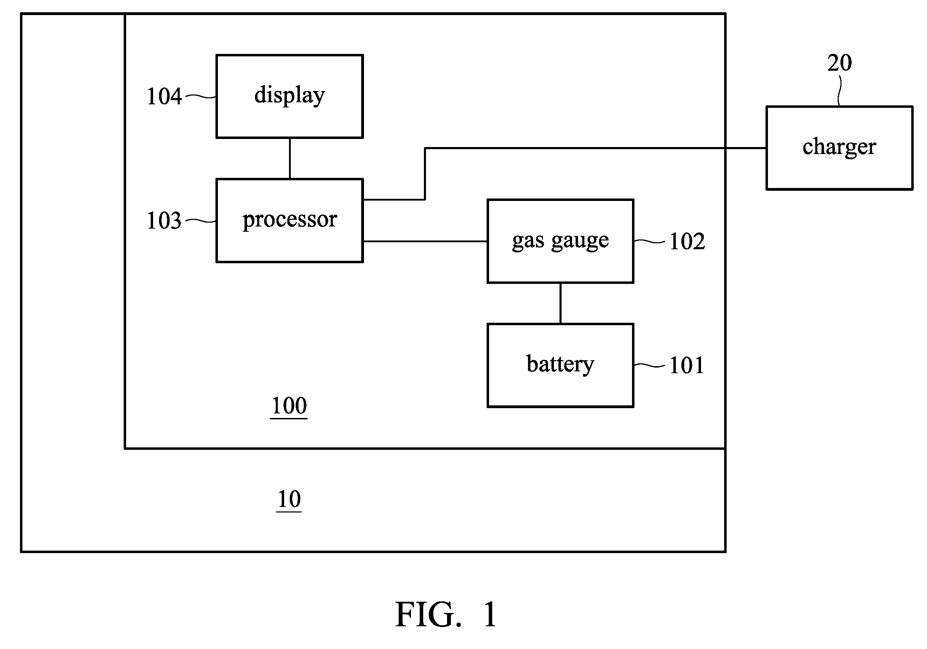

Fig. 1 is a block diagram of the state-detection device in accordance with an embodiment of the invention. As shown in Fig. 1, the host 10 includes the state-detection device 100 and is coupled to the charger 20. According to an embodiment of the invention, the host 10 can be a notebook computer, a hand-held electronic device, or any electronic device with a battery. As shown in Fig. 1, the state-detection device 100 includes the battery 101, the gas gauge 102, the processor 103, and the display 104. The detailed function of the state-detection device 100 will be described in the following paragraphs.

According to an embodiment of the invention, the battery 101 is operating in an operation state. The gas gauge 102 is configured to detect the operation state of the battery 101, and stores the operation information of the battery 101 in a plurality of registers (not shown in Fig. 1). According to an embodiment of the invention, the registers, which store the operation information, are located in the gas gauge 102. The gas gauge 102 instantly detects the operation state of the battery 101 and instantly updates the operation information stored in the registers. According to another embodiment of the information, the registers are not limited to being located in the gas gauge 102.

According to the state information stored in the registers, the processor 103 determines that the battery 101 will operate in either the normal state, the temporary failure state, or the permanent failure state, to generate the state-determination information, according to an embodiment of the invention. According to an embodiment of the invention, the processor 103 displays the state-determination information to the user by using the display 104. According to an embodiment of the invention, the processor 103 further detects whether the charger 20 is coupled to the host 10 or not to determine whether the battery 101 is in the charging state or the discharging state.

According to another embodiment of the invention, after accessing the state information in the registers, the processor 103 decodes the state information and, according to the decoded state information, the processor 103 determines whether the battery 101 is operating in the normal state, the temporary failure state, or the permanent failure state to generate the state-determination information. The state-determination information is displayed by the display 104. When the battery 101 is operating in either the temporary failure state or the permanent failure state, the processor 103 displays the troubleshooting suggestion by the display 104. The normal state, the temporary failure state, and the permanent state will be individually described in the following paragraphs.

### Normal State

Table 1 shows the state information, the state-determination information, and the troubleshooting suggestion of the battery 101, which are displayed by the display 104, in accordance with an embodiment of the invention. As shown in Table 1, the battery life, the battery count, the battery capacity, the battery current, the battery voltage, and the battery temperature are obtained by the processor 103 accessing the state information of the battery 101 which is stored in the registers. The charging or discharging state of the battery 101 shown in Table 1 is determined by the processor 103. The processor 103 determines that the battery 101 is operating in either the charging state or the discharging state based on whether the charger 20 is coupled to the host 10 or not.

According to an embodiment of the invention, the processor 103 accesses the state information in the registers in a predetermined time interval a predetermined number of times to determine whether the operation state of the battery 101 is the normal state, the temporary failure state, or the permanent failure state. According to an embodiment of the invention, the predetermined time interval is 1 minute, and the predetermined number of times is 3 times. According to another embodiment of the invention, the user is able to adjust the predetermined time interval and the predetermined number of times. As shown in Table 1, since the error code is not displayed, it represents that there is no abnormality with the battery 101, so that the state-determination information shows that the battery 101 is operating in the normal state, and there are no troubleshooting suggestions.

**Table 1**

| Battery and Charger | | | |
|---|---|---|---|
| State Information | Current | Max | Min |
| Battery Health | 100% | 100% | 100% |
| Battery Count | 6 | 6 | 6 |
| Battery Capacity | 46% | 46% | 41% |
| Battery Current Flow | 1000mA | 1000mA | 515mA |
| Battery Voltage Flow | 7400mV | 7400mV | 7200mV |
| Battery Temperature Flow | 38°C | 38°C | 25°C |
| Battery Charging State | Charging | N.A. | N.A. |
| Detect | 3^{rd} | 2^{nd} | 1^{st} |
| Error Code | N.A. | N.A. | N.A. |
| State-Determination Information | Normal State | | |
| Troubleshooting Suggestion | N.A. | | |

### Temporary Failure State

When the battery 101 is operating in the temporary failure state, the processor 103 further distinguishes whether the temporary failure state is the temporary failure state of the charging state or the temporary failure state of the discharging state, based on whether the charger 20 is coupled to the host 10 or not. According to an embodiment of the invention, when the temporary failure state has occurred in the charging state, the processor 103 determines whether the temporary failure state is the over-temperature state, the over-voltage state, or the over-current state, according the first value, the second value, and the third value, respectively, of the state information stored in the registers. The first value, the second value, and the third value will be described in detail in the following description.

According to another embodiment of the invention, when the temporary failure state has occurred in the discharging state, the processor 103 determines that the temporary failure state is the over-temperature state or the over-current state according the first value and the fourth value, respectively, of the state information stored in the registers.

That is, in the charging state, the temporary failure state is subdivided into the over-temperature state, the over-voltage state, and the over-current state; in the discharging state, the temporary failure state is subdivided into the over-temperature state and the over-current state. In addition, the processor 103 determines whether the temporary failure state is the over-temperature state, the over-voltage state, or the over-current state, by the respective bits of the registers which store the state information.

### Temporary Failure State of The Charging State

Table 2 shows the state information, the state-determination information, and the troubleshooting suggestion displayed by the display 104 when the battery 101 is operating in the temporary failure state of the charging state, in accordance with an embodiment of the invention. As shown in Table 2, since the current temperature has been up to 64°C and the highest temperature has been up to 65°C, it represents that the temporary failure state at the time is caused by the host 10 automatically shutting down due to over-temperature protection. Therefore, the error code being TF means that the battery 101 is operating in the temporary failure state at the time, and the display 104 displays that the temporary failure state is the over-temperature state by the state-determination information. According to an embodiment of the invention, the user can release the temporary failure state by lowering the temperature down to 50°C, or below 50°C, according to the troubleshooting suggestion displayed by the display 104.

According to an embodiment of the invention, the processor 103 determines whether the temporary failure state is the over-temperature state or not based on the Over Temperature Alarm (OTA) bit in the registers. According to another embodiment of the invention, the processor 103 determines whether the temporary failure state is the over-temperature state or not based on the 12^{th} bit of 0x16 register of the registers which store the operation information.

**Table 2**

| Battery and Charger | | | |
|---|---|---|---|
| State Information | Current | Max | Min |
| Battery Health | 100% | 100% | 100% |
| Battery Count | 3 | 3 | 3 |
| Battery Capacity | 46% | 46% | 41% |
| Battery Current Flow | 517mA | 1000mA | 515mA |
| Battery Voltage Flow | 7400mV | 7400mV | 7200mV |
| Battery Temperature Flow | 64°C | 65°C | 25°C |
| Battery Charging State | Charging | N.A. | N.A. |
| Detect | 3^{rd} | 2^{nd} | 1^{st} |
| Error Code | TF | TF | N.A. |
| State-Determination Information | Over-Temperature State | | |
| Troubleshooting Suggestion | Temperature down to 50°C | | |

**Table 3**

| Battery and Charger | | | |
|---|---|---|---|
| State Information | Current | Max | Min |
| Battery Health | 100% | 100% | 100% |
| Battery Count | 2 | 2 | 2 |
| Battery Capacity | 46% | 46% | 41% |
| Battery Current Flow | 1500mA | 7000mA | 515mA |
| Battery Voltage Flow | 7400mV | 7400mV | 7200mV |
| Battery Temperature Flow | 38°C | 38°C | 25°C |
| Battery Charging State | Charging | N.A. | N.A. |
| Detect | 3^{rd} | 2^{nd} | 1^{st} |
| Error Code | TF | TF | TF |
| State-Determination Information | Over-Current State | | |
| Troubleshooting Suggestion | Shutdown and Remove the charger for a period | | |

Table 3 shows the state information, the state-determination information, and the troubleshooting suggestion displayed by the display 104 when the battery 101 is operating in the temporary failure state of the charging state, in accordance with another embodiment of the invention. As shown in Table 3, since the highest battery current has been up to 7000mA, it represents that the temporary failure state at the time is caused by the host 10 automatically shutting down due to over-current protection. Therefore, the error code being TF means that the battery 101 is operating in the temporary failure state at the time, and the display 104 displays that the temporary failure state is the over-current state by the state-determination information. According to an embodiment of the invention, the user can release the temporary failure state by shutting down the host 10 and removing the charger 20 for a predetermined period according to the troubleshooting suggestion displayed by the display 104. According to an embodiment of the invention, the predetermined period is 10 sec.

According to an embodiment of the invention, the processor 103 determines whether the temporary failure state is the over-current state or not based on the Charge Overcurrent Condition (OCC) bit in the registers. According to another embodiment of the invention, the processor 103 determines whether the temporary failure state is the over-current state or not based on the 2^{nd} bit of 0x51 register of the registers which store the operation information.

Table 4 shows the state information, the state-determination information, and the troubleshooting suggestion displayed by the display 104 when the battery 101 is operating in the temporary failure state of the charging state, in accordance with another embodiment of the invention. As shown in Table 4, since the highest battery voltage has been up to 8600mV, it represents that the temporary failure state at the time is caused by the host 10 automatically shutting down due to over-voltage protection. Therefore, the error code being TF means that the battery 101 is operating in the temporary failure state at the time, and the display 104 displays that the temporary failure state is the over-voltage state by the state-determination information. According to an embodiment of the invention, the user can release the temporary failure state by shutting down the host 10 and removing the charger 20 for a predetermined period according to the troubleshooting suggestion displayed by the display 104. According to an embodiment of the invention, the predetermined period is 10 sec.

**Table 4**

| Battery and Charger | | | |
|---|---|---|---|
| State Information | Current | Max | Min |
| Battery Health | 100% | 100% | 100% |
| Battery Count | 5 | 5 | 5 |
| Battery Capacity | 46% | 46% | 41% |
| Battery Current Flow | 517mA | 1000mA | 515mA |
| Battery Voltage Flow | 7400mV | 8600mV | 7200mV |
| Battery Temperature Flow | 38°C | 38°C | 25°C |
| Battery Charging State | Charging | N.A. | N.A. |
| Detect | 3^{rd} | 2^{nd} | 1^{st} |
| Error Code | TF | TF | N.A. |
| State-Determination Information | Over-Voltage State | | |
| Troubleshooting Suggestion | Shutdown and Remove the charger for a period | | |

According to an embodiment of the invention, the processor 103 determines whether the temporary failure state is the over-voltage state or not based on the Cell Overvoltage Condition (COV) bit in the registers. According to another embodiment of the invention, the processor 103 determines whether the temporary failure state is the over-voltage state or not based on the 1^{st} bit of 0x51 register of the registers which store the operation information.

### Temporary Failure State of The Discharging State

Table 5 shows the state information, the state-determination information, and the troubleshooting suggestion displayed by the display 104 when the battery 101 is operating in the temporary failure state of the discharging state, in accordance with an embodiment of the invention. As shown in Table 5, since the current temperature has been up to 64°C and the highest temperature has been up to 65°C, it represents that the temporary failure state at the time is caused by the host 10 automatically shutting down due to over-temperature protection. Therefore, the error code being TF means that the battery 101 is operating in the temporary failure state at the time, and the display 104 displays that the temporary failure state is the over-temperature state by the state-determination information. According to an embodiment of the invention, the user can release the temporary failure state by lowering the temperature down to 50°C, or below 50°C, according to the troubleshooting suggestion displayed by the display 104.

**Table 5**

| Battery and Charger | | | |
|---|---|---|---|
| State Information | Current | Max | Min |
| Battery Health | 100% | 100% | 100% |
| Battery Count | 3 | 3 | 3 |
| Battery Capacity | 46% | 46% | 41% |
| Battery Current Flow | -517mA | -1000mA | -515mA |
| Battery Voltage Flow | 7400mV | 8600mV | 7200mV |
| Battery Temperature Flow | 64°C | 65°C | 25°C |
| Battery Charging State | Discharging | N.A. | N.A. |
| Detect | 3^{rd} | 2^{nd} | 1^{st} |
| Error Code | TF | TF | N.A. |
| State-Determination Information | Over-Temperature State | | |
| Troubleshooting Suggestion | Temperature down to 50°C | | |

According to an embodiment of the invention, the processor 103 determines whether the temporary failure state is the over-temperature state or not based on the Over Temperature Alarm (OTA) bit in the registers. According to another embodiment of the invention, the processor 103 determines whether the temporary failure state is the over-temperature state or not based on the 12^{th} bit of 0x16 register of the registers which store the operation information. That is, the processor 103 determines whether the temporary failure state of both the charging and discharging state is the over-temperature state or not based on the 12^{th} bit of 0x16 register of the registers which store the operation information.

Table 6 shows the state information, the state-determination information, and the troubleshooting suggestion displayed by the display 104 when the battery 101 is operating in the temporary failure state of the discharging state, in accordance with another embodiment of the invention. As shown in Table 6, since the highest battery current has been up to 7000mA, it represents that the temporary failure state at the time is caused by the host 10 automatically shutting down due to over-current protection. Therefore, the error code being TF means that the battery 101 is operating in the temporary failure state at the time, and the display 104 displays that the temporary failure state is the over-current state by the state-determination information. The user can release the temporary failure state according to the troubleshooting suggestion.

According to an embodiment of the invention, the user can release the temporary failure state by shutting down the host 10 and removing the charger 20 for a predetermined period according to the troubleshooting suggestion displayed by the display 104. According to an embodiment of the invention, the predetermined period is 10 sec.

**Table 6**

| Battery and Charger | | | |
|---|---|---|---|
| State Information | Current | Max | Min |
| Battery Health | 100% | 100% | 100% |
| Battery Count | 2 | 2 | 2 |
| Battery Capacity | 46° | 46% | 41% |
| Battery Current Flow | 1500mA | 7000mA | 515mA |
| Battery Voltage Flow | 7400mV | 7400mV | 7200mV |
| Battery Temperature Flow | 38°C | 38°C | 25°C |
| Battery Charging State | Discharging | N.A. | N.A. |
| Detect | 3^{rd} | 2^{nd} | 1^{st} |
| Error Code | TF | TF | TF |
| State-Determination Information | Over-Current State | | |
| Troubleshooting Suggestion | Shutdown and Remove the charger for a period | | |

According to an embodiment of the invention, the processor 103 determines whether the temporary failure state is the over-current state or not based on the Discharge Overcurrent Condition (OCD) bit in the registers. According to another embodiment of the invention, the processor 103 determines whether the temporary failure state is the over-current state or not based on the 4^{th} bit of 0x51 register of the registers which store the operation information.

### Permanent Failure State

Table 7 shows the state information, the state-determination information, and the troubleshooting suggestion displayed by the display 104 when the battery 101 is operating in the permanent failure state of the discharging state, in accordance with an embodiment of the invention. As shown in Table 7, although the battery current, the battery voltage, and the battery temperature are normal, the error code being PF means the battery 101 is operating in the permanent failure state, and that the battery 101 is abnormal due to another, unknown situation having occurred. Therefore, the state-determination information shows that the battery 101 is operating in the permanent failure state. According to an embodiment of the invention, the user can contact customer service to expel the phenomena according to the troubleshooting suggestion.

**Table 7**

| Battery and Charger | | | |
|---|---|---|---|
| State Information | Current | Max | Min |
| Battery Health | 100% | 100% | 100% |
| Battery Count | 6 | 6 | 6 |
| Battery Capacity | 46% | 46% | 41% |
| Battery Current Flow | 517mA | 1000mA | 515mA |
| Battery Voltage Flow | 7400mV | 7400mV | 7200mV |
| Battery Temperature Flow | 38°C | 38°C | 25°C |
| Battery Charging State | Charging | N.A. | N.A. |
| Detect | 3^{rd} | 2^{nd} | 1^{st} |
| Error Code | PF | PF | PF. |
| State-Determination Information | Permanent Failure State | | |
| Troubleshooting Suggestion | Please Contact Customer Service | | |

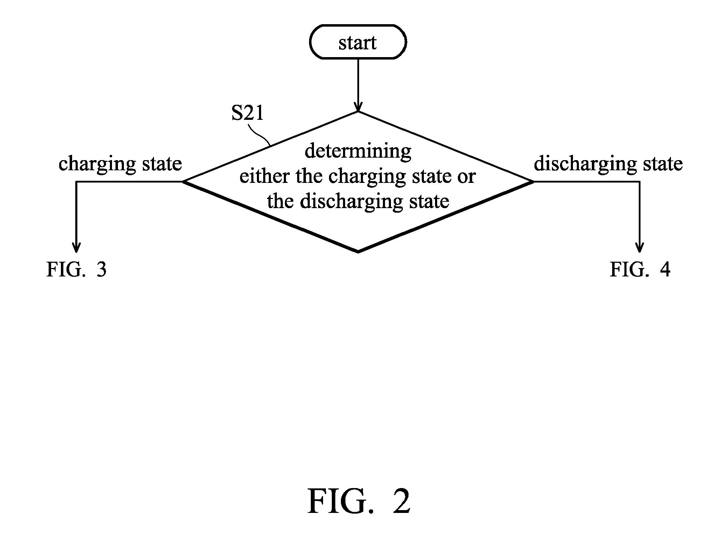

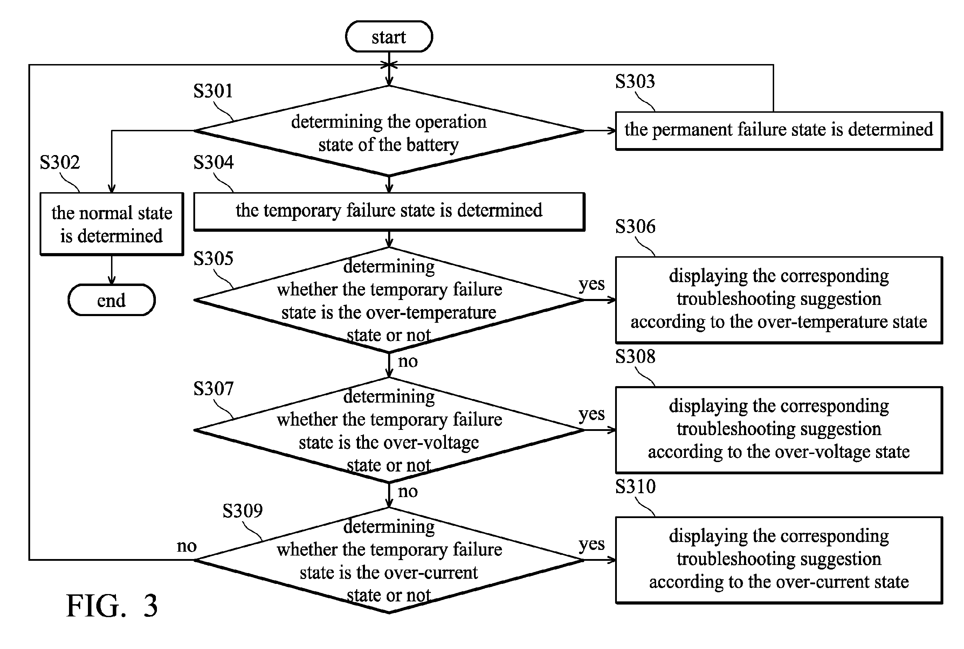

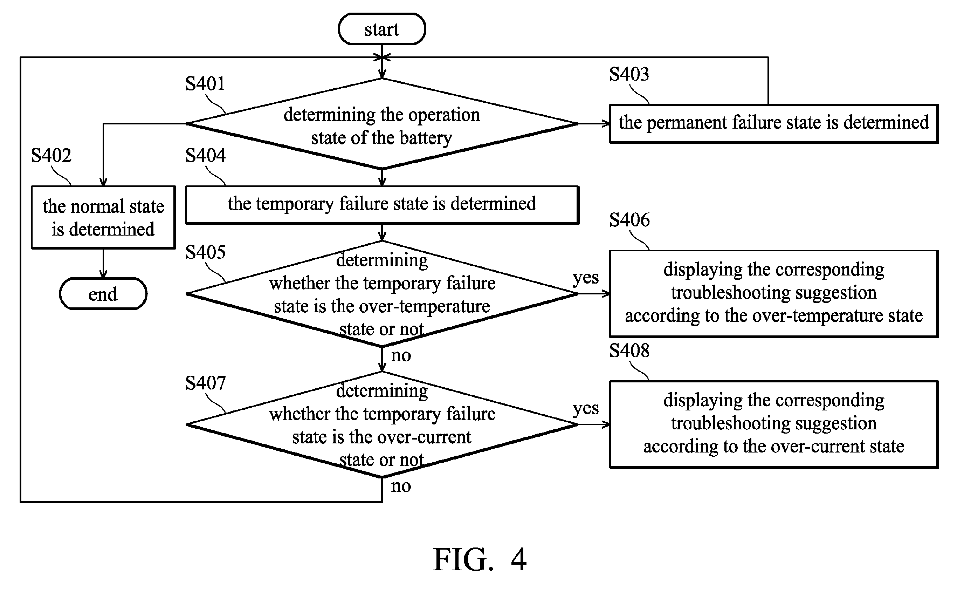

Fig. 2 is a flow chart of the state detection method in accordance with an embodiment of the invention. In the following description, the flow chart will be described in detail with the block diagram of Fig. 1. As shown in Fig. 2, the processor 103 firstly determines that the battery 101 is operating in either the charging state or the discharging state (Step S21). When the battery 101 is operating in the charging state, the flow chart of Fig. 3 has been entered; when the battery 101 is operating in the discharging state, the flow chart of Fig. 4 has been entered.

Fig. 3 is a flow chart of the state detection method during the charging state in accordance with an embodiment of the invention. First, the processor 103 determines whether the battery 101 is operating in the normal state, the temporary failure state, or the permanent failure state according to the state information stored in the registers (Step S301). When the normal state has been determined (Step 302), the state detection method is stopped; when the permanent failure state has been determined (Step 303), it goes back to Step S301 in order to avoid any misjudgments.

When the temporary failure state has been determined (Step S304), the processor 103 further determines whether the temporary failure state is the over-temperature state or not (Step S305). According to an embodiment of the invention, the processor 103 determines whether the temporary failure state is the over-temperature state based on the Over Temperature Alarm (OTA) bit in the registers. According to another embodiment of the invention, the processor 103 determines whether the temporary failure state is the over-temperature state or not based on the 12^{th} bit of 0x16 register of the registers which store the operation information.

When the over-temperature has been determined in Step S305, the processor 103 displays the corresponding troubleshooting suggestion by the display 104, according to the over-temperature state (Step S306). According to an embodiment of the invention, the troubleshooting suggestion of the over-temperature state is to lower the temperature down to 50°C, or below 50°C. The user can release the temporary failure state according to the troubleshooting suggestion displayed by the display 104.

Back to Step S305, when the processor 103 determines that the temporary failure state is not the over-temperature state, the processor 103 further determines whether the temporary failure state is the over-voltage state or not (Step S307). According to an embodiment of the invention, the processor 103 determines whether the temporary failure state of the charging state is the over-voltage state or not according to the Cell Overvoltage Condition (COV) bit of the registers. According to another embodiment of the invention, the processor 103 determines whether the temporary failure state of the charging state is the over-voltage state or not based on the 1^{st} bit of 0x51 register of the registers which store the operation information.

Back to Step S307, when the processor 103 determines that the temporary failure state is the over-voltage state, the processor 103 displays the corresponding troubleshooting suggestion by the display 104 according to the over-voltage state (Step S308). According to an embodiment of the invention, the troubleshooting suggestion of the over-voltage state is to shut down the host 10 and to remove the charger 20 for a predetermined period, and the user can release the temporary failure state according to the troubleshooting suggestion displayed by the display 104. According to an embodiment of the invention, the predetermined period is 10 seconds.

Back to Step S307, when the processor 103 determines that the temporary failure state is not the over-voltage state, the processor 103 further determines whether the temporary failure state is the over-current state or not (Step S309). According to an embodiment of the invention, the processor 103 determines whether the temporary failure state of the charging state is the over-current state or not according to the Charge Overcurrent Condition (OCC) bit of the registers. According to another embodiment of the invention, the processor 103 determines whether the temporary failure state of the charging state is the over-current state or not based on the 2^{nd} bit of 0x51 register of the registers which store the operation information.

Back to Step S309, when the processor 103 determines that the temporary failure state is the over-current state, the processor 103 displays the corresponding troubleshooting suggestion by the display 104 according to the over-current state (Step S310). According to an embodiment of the invention, the troubleshooting suggestion of the over-current state is to shut down the host 10 and to remove the charger 20 for a predetermined period, and the user can release the temporary failure state according to the troubleshooting suggestion displayed by the display 104. According to an embodiment of the invention, the predetermined period is 10 seconds. Back to Step 309, when the processor 103 determines that the temporary failure state is not the over-current state, it goes back to Step S301.

Fig. 4 is a flow chart of the state detection method during the discharging state in accordance with an embodiment of the invention. Since only the over-temperature state and the over-current state should be detected in the temporary failure state of the discharging state, as shown in Fig. 4, Step S401 to Step S406 are respectively identical to Step S301 to Step S306 in Fig. 3, and Step 407 and Step 408 in Fig. 4 are respectively identical to Step S309 and Step S310 in Fig. 3.

In Step S405, according to an embodiment of the invention, the processor 103 determines whether the temporary failure state is the over-temperature state based on the Over Temperature Alarm (OTA) bit in the registers. According to another embodiment of the invention, the processor 103 determines whether the temporary failure state is the over-temperature state or not based on the 12^{th} bit of 0x16 register of the registers which store the operation information.

When the over-temperature state has been determined in Step S405, the processor 103 displays the corresponding troubleshooting suggestion by the display 104 according to the over-temperature state (Step S406). According to an embodiment of the invention, the troubleshooting suggestion of the over-temperature state is to lower the temperature down to 50°C, or below 50°C, and the user can release the temporary failure state according to the troubleshooting suggestion displayed by the display 104.

In Step S407, according to an embodiment of the invention, the processor 103 determines whether the temporary failure state of the discharging state is the over-current state or not based on the Discharge Overcurrent Condition (OCD) bit in the registers. According to another embodiment of the invention, the processor 103 determines whether the temporary failure state of the discharging state is the over-current state or not based on the 4^{th} bit of 0x51 register of the registers which store the operation information.

When the over-current state has been determined in Step S407, the processor 103 displays the corresponding troubleshooting suggestion by the display 104 according to the over-current state (Step S408). The troubleshooting suggestion of the over-current state is to shut down the host 10 and to remove the charger 20 for a predetermined period, and the user can release the temporary failure state according to the troubleshooting suggestion displayed by the display 104. According to an embodiment of the invention, the predetermined period is 10 seconds. Back to Step S407, when the processor 103 determines that it is not the over-current state, it goes back to Step S401.

The invention discloses the reasons why the battery 101 is operating in the temporary failure state based on the operation state of the battery 101 which is detected by the gas gauge 102 and stored in the registers, and that the troubleshooting suggestion is provided to the user based on the reasons why the temporary failure state has occurred. Users can troubleshoot problems by themselves according to the troubleshooting suggestions, and can understand the status of the battery.

While the invention has been described by way of example and in terms of preferred embodiment, it is to be understood that the invention is not limited thereto. Those who are skilled in this technology can still make various alterations and modifications without departing from the scope and spirit of this invention. Therefore, the scope of the present invention shall be defined and protected by the following claims and their equivalents.

## Claims

1. A state-detection device, adapted to a host, comprising:
a battery, operating in an operation state;
a gas gauge, configured to instantly detect the operation state to store state information of the battery in a plurality of registers;
a processor, determining, according to the state information, whether the battery is operating in either a normal state, a temporary failure state, or a permanent failure state to generate state-determination information, wherein when the battery is operating in the temporary failure state, the processor further determines whether the temporary failure state is an over-temperature state, an over-voltage state, or an over-current state according to a first value, a second value, and a third value, respectively, of the state information; and
a display, configured to display the state-determination information.

2. The state-detection device of claim 1, wherein the processor further determines whether the operation state is a charging state or a discharging state according to whether a charger is coupled to the host or not, wherein when the operation state is the temporary failure state of the charging state, the processor determines whether the temporary failure state is the over-temperature state based on an Over Temperature Alarm bit, whether the temporary failure state is the over-voltage state based on a Cell Overvoltage Condition bit, or whether the temporary failure state is the over-current state based on a Charge Overcurrent Condition bit.

3. The state-detection device of claim 2, wherein when the operation state is the temporary failure state of the discharging state, the processor determines whether the temporary failure state is the over-temperature state based on an Over Temperature Alarm bit, or whether the temporary failure state is the over-current state based on a Discharge Overcurrent Condition bit.

4. The state-detection device of claim 1, wherein when the operation state is the temporary failure state, the processor further displays, on the display, a troubleshooting suggestion corresponding to the over-temperature state, the over-voltage state, or the over-current state, so that a user is able to put the operation state back to the normal state according to the troubleshooting suggestion.

5. The state-detection device of claim 1, wherein the processor accesses the state information of the registers in a predetermined time interval a predetermined number of times, and determines that the operation state of the battery is the normal state, the temporary failure state, or the permanent failure state according to the state information that has been accessed the predetermined number of times, wherein when the operation state is the temporary failure state, the processor determines whether the temporary failure state is the over-temperature state, the over-voltage state, or the over-current state according to the state information that has been accessed the predetermined number of times.

6. A state detection method, adapted for a battery of a host, comprising:
instantly detecting an operation state to generate state information;
storing the state information in a plurality of registers;
determining, according to the state information, whether the battery is operating in a normal state, a temporary failure state, or a permanent failure state to generate state-determination information;
when the battery is operating in the temporary failure state, determining whether the temporary failure state is an over-temperature state, an over-voltage state, or an over-current state, according to a first value, a second value, and a third value, respectively, of the state information; and
displaying the state-determination information by a display.

7. The state detection method of claim 6, further comprising:
determining that the operation state is a charging state or a discharging state according to whether a charger is coupled to the host or not;
when the operation state is the temporary failure state of the charging state, determining whether the temporary failure state is the over-temperature state or not based on an Over Temperature Alarm bit;
determining whether the temporary failure state is the over-voltage state or not based on a Cell Overvoltage Condition bit; and
determining whether the temporary failure state is the over-current state or not based on a Charge Overcurrent Condition bit.

8. The state detection method of claim 7, further comprising:
when the operation state is the temporary failure state of the discharging state, determining whether the temporary failure state is the over-temperature state or not based on the Over Temperature Alarm bit; and
determining whether the temporary failure state is the over-current state or not based on a Discharge Overcurrent Condition bit.

9. The state detection method of claim 6, further comprising:
when the operation state is the temporary failure state, displaying, by the display, a troubleshooting suggestion corresponding to each of the over-temperature state, the over-voltage state, and the over-current state, so that a user is able to put the operation state back to the normal state according to the troubleshooting suggestion.

10. The state detection method of claim 6, further comprising:
accessing the state information of the registers in a predetermined interval a predetermined number of times;
determining whether the operation state of the battery is the normal state, the temporary failure state, or the permanent failure state, according to the state information that has been accessed the predetermined number of times; and
when the operation state is the temporary failure state, determining whether the temporary failure state is the over-temperature state, the over-voltage state, or the over-current state, according to the state information that has been accessed the predetermined number of times.
